Europäisches Patentamt

European Patent Office

Office européen des brevets

(11) Publication number: **0 350 100**
**A1**

## EUROPEAN PATENT APPLICATION

(21) Application number: 89201712.0

(22) Date of filing: 28.06.89

(51) Int. Cl.4: **H05K 13/02 , F15B 15/16**

(30) Priority: 04.07.88 NL 8801684

(43) Date of publication of application:
**10.01.90 Bulletin 90/02**

(84) Designated Contracting States:
**CH DE FR GB IT LI**

(71) Applicant: **N.V. Philips' Gloeilampenfabrieken**
**Groenewoudseweg 1**
**NL-5621 BA Eindhoven(NL)**

(72) Inventor: **Faes, Franciscus Cornelius Maria**
**c/o INT. OCTROOIBUREAU B.V. Prof.**
**Holstlaan 6**
**NL-5656 AA Eindhoven(NL)**
Inventor: **Van de Ven, Johannes Theodorus**
**Antonius**
**c/o INT. OCTROOIBUREAU B.V. Prof.**
**Holstlaan 6**
**NL-5656 AA Eindhoven(NL)**

(74) Representative: **Melio, Jan Dirk et al**
**INTERNATIONAAL OCTROOIBUREAU B.V.**
**Prof. Holstlaan 6**
**NL-5656 AA Eindhoven(NL)**

(54) **Device for removing articles from an elongate holder.**

(57) A device for removing articles from an elongate holder, in which the articles are arranged in a row. The device comprises a cylinder (3) with a pushing member composed of a number of cylindrical parts (9, 11, 15) telescopically displaceable with respect to each other by means of pressurized air, which have such a diameter that they can penetrate into the space of the holder receiving the articles. The device is particularly suitable for emptying rod-shaped magazines, in which electronic components are arranged.

FIG.3

## Device for removing articles from an elongate holder.

The invention relates to a device for removing articles from an elongate holder, which is open at its two ends and in which a number of articles, viewed in the longitudinal direction of the holder, are arranged in a row.

In the technique it is common practice to supply small articles, which must be processed, for example, by a machine, such as for mounting of the articles, in elongate holders, from which these articles must be removed one by one during processing. It is known from US PS 4,573,261 to arrange such an elongate holder vertically for removing articles therefrom so that the articles move under the influence of the force of gravity to the lower side of the holder and can be removed there one by one. When articles are removed from the holder solely under the influence of the force of gravity, a regular and uniform removal of the articles from the holder cannot be guaranteed because variations can occur in the frictional force between articles and holder, for example due to the presence of moisture and/or dirt, unevennesses on the articles and/or the holder and variations in the force exerted on an article by the articles present above the relevant article in the holder, the number of which gradually decreases during the removal of the articles. When utilizing the force of gravity for the removal of the articles from the holder, the holder must also extend upwards, as a result of which in many cases the articles do not leave the holder in a position in which they must be further processed.

The invention has for its object to provide a device of the kind mentioned above, by means of which a regular removal of articles from a holder can be guaranteed, independently of the position occupied by the holder.

According to the invention, this can be achieved in that the device is provided with a cylinder with a pistonlike body, which is slidably arranged in the cylinder and to which an elongate pushing member is secured, while the cylinder is provided with passages, through which pressurized fluid can be fed into the cylinder on one as well as on the other side of the pistonlike body, in a manner such that the pushing member can be moved to and fro between a retracted position, in which the pushing member is located in the cylinder at least for the major part, and an extended position, in which the pushing member projects from the cylinder at least for the major part.

With the use of the device, by supply of pressurized fluid, such as, for example, pressurized air, the pushing member, which fits into the space of the holder receiving the articles, can be pushed gradually into said space so that the articles are pushed in front of the pushing member at the end remote from the pushing member out of the holder. The speed at which this takes place can also be regulated in a simple manner be regulating the supply of the pressurized fluid.

After the last article has been pushed out of the holder, the pushing member can be rapidly withdrawn again from the holder by supply of pressurized fluid, after which again a new holder can be arranged opposite to the pushing member.

The invention will now be described more fully with reference to a few possible embodiments of the device according to the invention shown in the accompanying Figures.

Figure 1 shows diagrammatically in elevation a holder with a number of articles arranged therein,

Figure 2 is a side elevation of Figure 1,

Figure 3 shows diagrammatically in sectional view a first embodiment of a device according to the invention with a telescopic pushing member in fully extended position,

Figure 4 shows a sectional view corresponding to Figure 3, in which the pushing member is partly retracted,

Figure 5 shows a sectional view corresponding to Figure 4, in which the pushing member is retracted farther than in the position shown in Figure 4,

Figure 6 is a sectional view of the device shown in Figures 3 to 5 with fully retracted pushing member, and

Figure 7 is a sectional view of a second embodiment of a device according to the invention.

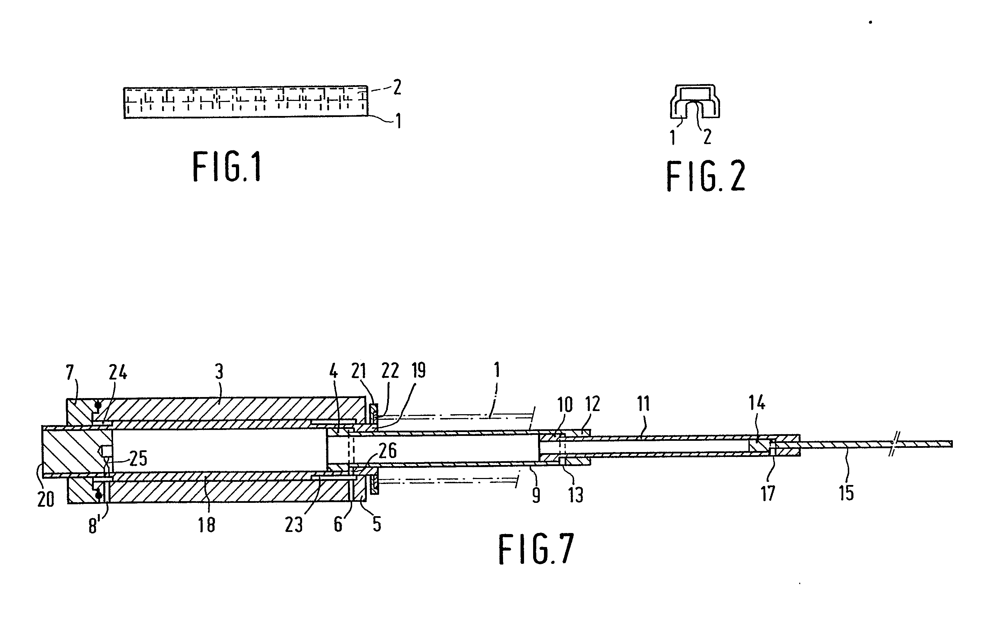

Figures 1 and 2 show an elongate holder 1, in which, viewed in the longitudinal direction of the holder, a number of articles 2, in the embodiment shown electronic components, are arranged in a row. Such holders are mostly utilized as a magazine for storing and transporting the articles 2 and for processing the articles 2 the latter are successively removed from the holder by displacing them in the longitudinal direction of the holder in such a manner that the articles leave the holder one by one near an end of the holder.

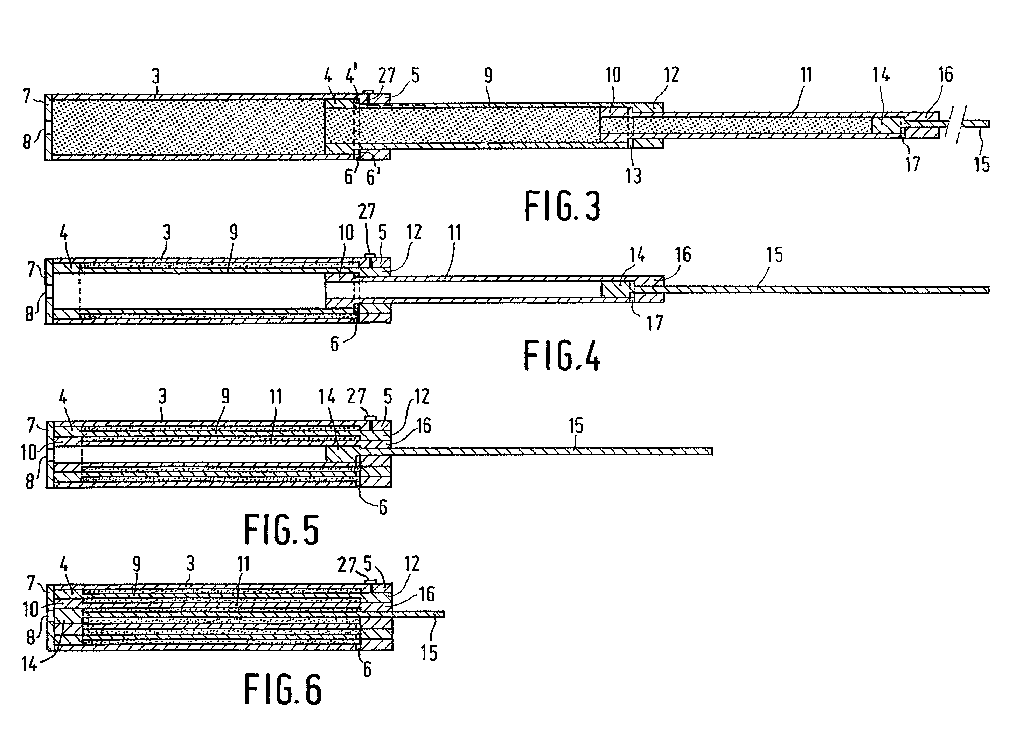

The articles can be pushed out of the holder by means of the device shown in Figures 3 to 6. This device is provided with a cylinder 3, in which a pistonlike body 4 is arranged. In the position shown in Figure 3, the pistonlike body 4 engages by a cam 4' the righthand end wall 5 of the cylinder 3, viewed in Figure 3. The wall of the cylinder 3 is provided with a passage 6 for feeding pressurized fluid into the interior of the cylinder 3 in the annular space 6' located, viewed in Figure 3, on the righthand side of the pistonlike body 4. The annular space 6' occupies substantially the whole circumference of the pistonlike body 4, except the cam 4'. The other end wall 7 of the cylinder 3 is provided with a further passage 8 for feeding pressurized fluid into the cylinder 3 on the lefthand side of the pistonlike body 4, viewed in Figure 3.

The hollow pistonlike body 4 is further made integral with a sleeve, 9, which is secured thereto and is guided in a sealing manner in a passage provided in the cylinder wall 5 and projects in the position shown in Figure 3 over the major part of its length from the cylinder 3.

The sleeve 9 constitutes a cylinder for a pistonlike body 10 slidable in the sleeve 9. The hollow pistonlike body 10 is again integral with a further sleeve 11, which is slidably guided in a bore provided in an end wall 12 of the sleeve 9. The end wall 12 of the sleeve 9 is further provided with a passage 13, which, viewed in Figure 3, merges in the interior of the sleeve 9 into an annular space, which is located on the righthand side of the pistonlike body 10.

The sleeve 11 in turn constitutes a cylinder for a pistonlike body 14 slidable in this sleeve 11. The pistonlike body has secured to it a rod 15, which is passed through a passage provided in the wall 16 closing the sleeve 11 at its end remote from the pistonlike body 10. The wall 16 is provided with a passage 17 in such a manner that this passage merges in the interior of the sleeve into an annular space, which, viewed in Figure 3, is located on the righthand side of the pistonlike body 14. In figure 3, the pushing member, which is constituted by the sleeves 9 and 11 and the rod 15, is shown in a position fully extended with respect to the cylinder 3. The pushing member constituted by the parts 9, 11 and 15 telescopically displaceable with respect to each other can be retracted into the cylinder 3 by admitting pressurized fluid through the passage 6 into the annular space 6', while fluid present in the cylinder 3 can flow away through the passage 8. When admitting pressurized fluid into the space 6' through the passage 6, the pistonlike body 4 will be displaced by this fluid from the position shown in Figure 3 to the position shown in Figure 4, in which the pistonlike body engages the end wall 7 of the cylinder 3. The construction is then so that in this position the passage 13 in the end wall 12 of the cylinder 9 is located in line with the passage 6. Consequently, pressurized fluid supplied through the passage 6 will flow through the passage 13 into the annular space on the righthand side of the pistonlike body 10, as a result of which the pistonlike body 10, viewed in the Figures, will be displaced in the sleeve 9 to the left until it engages the end wall 7 of the cylinder 3, as shown in Figure 5. In this position, the passages 6, 13 and 17 will be located in line with each other so that pressurized fluid can flow through these passages into the annular space on the righthand side of the pistonlike body 14. This results in that also the pistonlike body 14, viewed in the Figures, will be displaced to the left until this pistonlike body also engages the end wall 7 of the cylinder 3, as shown in Figure 6. In this position, the rod 15 still projects over a small distance from the cylinder 3.

In the fully retracted position of the device shown in Figure 6, an elongate holder can be arrangd with one end opposite to the end of the rod 15 projecting from the cylinder 3 so that the holder will extend in line with this rod. Subsequently, pressurized fluid can be admitted through the passage 8 into the interior of the cylinder 3. As a result, first the pistonlike body 14 with the rod 15 secured thereto will be displaced, viewed in Figure 6, to the right until this pistonlike body engages the end wall of the sleeve 11. Viewed in the Figures, the sleeve 11 will then also be taken along to the right until the pistonlike body 10 engages the end wall 12 of the sleeve 9. Subsequently, also the sleeve 9 is taken along until it again occupies the position shown in Figure 3, in which the pushing member is again in a position fully extended with respect to the cylinder 3. It will be appreciated that during this step of moving the pushing member out of the cylinder 3, in which the pushing member is pushed into the interior of the elongate holder 1, the articles 2 arranged in this holder are pushed out of the elongate holder at the end remote from the device. The speed at which the articles are pushed, as the case may be intermittently, out of the elongate holder can be regulated by regulating the supply of pressurized fluid, for example air, by means of a suitable regulation valve or the like. The speed at which the pushing member is retracted can also be regulated by a suitable regulation of the supply of pressurized fluid through the passage 6. In general, the pushing member will be retracted considerably more rapidly than the pushing member is extended.

The embodiment of the device according to the invention shown in figure 7 roughly corresponds to the device described above with reference to Figures 3 to 6 and in Figure 7, those parts corresponding to the parts of the device shown in Figures 3 to 6 are therefore provided with the same reference numerals as used in Figures 3 to 6. However, as appears from Figure 7, the cylinder 3 accommodates a cylinder jacket 18, in whose interior the pistonlike body 4 is slidably arranged, while the sleeve 9 is slidably guided in a passage provided in an end wall 19 of the cylinder jacket.

The cylinder jacket 18 is slidably arranged in the cylinder 3 and the ends of the cylinder jacket, which have a smaller outer diameter than the central part of the cylinder jacket, are slidably guided in a sealing manner in a passage provided in the end wall 5 of the cylinder 3. Further, a plug 20 sealing the interior of the cylinder jacket from the environment is inserted into the end of the cylinder jacket 18 remote from the end wall 19. A ring 21 is arranged to surround the end of the end wall 19 of the cylinder jacket projecting from the cylinder 3 and is fixedly secured to the cylinder jacket. The surface of the ring 21 remote from the cylinder 3 is provided with a recess, in which a ring 22 made of resilient material is arranged.

As further appears from Figure 7, the passage 6 provided in the cylinder 3 merges into an annular space 23 formed between the inner wall of the cylinder 3 and the outer wall of the thinner end of the cylinder jacket 18. The passage 8 provided in the wall 7 according to the preceding embodiment is replaced by a passage 8′ in the end of the cylinder 3 located near the wall 7. This passage 8′ merges into an annular space 24 formed between the inner wall of the cylinder 3 and the outer wall of the lefthand end, viewed in Figure 7, of the cylinder jacket 18.

The space 24 is in open communication with the interior of the cylinder jacket 18 through a narrow passage 25 in the plug 20. The space 23 is also in communication with the interior of the cylinder jacket 18 through a passage 26 provided in the end wall 19 of the cylinder jacket 18, but on that side of the pistonlike body 4 which is remote from the space in the cylinder jacket 18 communicating with the passage 25.

Again the pushing member shown in Figure 7 in the extended position and constituted by the parts 9, 11 and 15 can be retracted by the supply of pressurized fluid through the passage 6. The pressurized fluid flowing into the space 23 will exert on the cylinder jacket 18 a force directed, viewed in Figure 7, to the lefthand side so that the cylinder jacket, viewed in Figure 7, will be slightly displaced to the left until the ring 21 engages the cylinder 3.

The pressurized fluid will further flow through the passage 26 into the interior of the cylinder jacket 18 so that consequently the pistonlike body 4 in the cylinder jacket will also be displaced, viewed in Figure 7, to the left until it engages the plug 20. Subsequently, in a similar manner as described above with reference to Figures 3 to 6, also the pistonlike bodies 10 and 14 with the components connected thereto will successively be displaced, viewed in Figure 7, to the left for fully retracting the pushing member.

When the pushing member has been fully retracted, an elongate holder 1 filled with articles can be placed with an end against the ring 22, as is indicated by dotted lines in Figure 7. If pressurized fluid is then admitted through the passage 8′ into the cylinder 3 for extending the pushing member and hence for sliding articles arranged in the holder 1 out of this holder, the fluid flowing through the passage 8′ into the space 24 will first move the cylinder jacket 18 with the ring secured thereto, viewed in Figure 7, to the right. This will also result in a displacement of the elongate holder 1 to the right, as a result of which the holder can be pressed with its end remote from the ring 22 against a supporting member or the like so that during the operation of removing articles from the holder the holder will be clamped between the device shown in Figure 7 and the relevant supporting member. After the holder has thus been clamped, the air can flow through the restricted passage 25 into the interior of the cylinder jacket 18, as a result of which the various parts of the telescopic pushing member can again be moved outwards with respect to the cylinder 3 in a similar manner as described above for pushing the articles arranged in the holder 1 out of this holder.

Undesired relative rotation of the parts telescopically displaceable with respect to each other can be prevented by means of a conventional pin-groove guide. For this purpose, for example, a pin is provided in the righthand end wall 5 of the cylinder 3, which pin is indicated in Figure 3 diagrammatically by reference numeral 27 and cooperates with a groove (not shown) on the outer circumference of the sleeve 9. The remaining parts are locked against rotation in a similar manner. Due to this measure, it is achieved that the passages 6, 13, 17 and 26 are located at least in line with each other in the retracted position of the pushing member.

Due to the telescopic construction of the pushing member, a device can be obtained which has a very small length in the retracted position of the pushing member so that the device is particularly suitable for incorporation into apparatuses for processing the article to be removed from the elongate holder. Depending upon the use, however, the pushing member may of course be composed of a larger or a smaller number of parts telescopically displaceable with respect to each other than is already indicated in the accompanying Figures, while the pushing member may also be made in one piece.

## Claims

1. A device for removing articles from an elongate holder, which is open at its two ends and in which a number of articles, viewed in the longitudinal direction of the holder, are arranged in a row, characterized in that the device is provided with a cylinder with a pistonlike body, which is slidably arranged in the cylinder and to which an elongate pushing member is secured, while the cylinder is provided with passages, through which pressurized fluid can be fed into the cylinder on one as well as on the other side of the pistonlike body, in a manner such that the pushing member can be moved to and fro between a retracted position, in which the pushing member is located in the cylinder at least for the major part, and an extended position, in which the pushing member projects from the cylinder at least for the major part.

2. A device as claimed in Claim 1, characterized in that the pushing member is composed of several parts telescopically displaceable with respect to each other.

3. A device as claimed in Claim 1 or 2, characterized in that an end of a sleeve is secured to the pistonlike body, which sleeve accommodates a second pistonlike body, which is displaceable in the longitudinal direction of the sleeve, while an elongate member projecting from the sleeve is secured to this second pistonlike body on the side remote from the first pistonlike body.

4. A device as claimed in Claim 3, characterized in that the elongate member is constituted by a sleeve, in which a further pistonlike body is displaceable, to which an elongate member is secured.

5. A device as claimed in Claim 3 or 4, characterized in that the sleeve is provided at its end remote from the pistonlike body secured to the sleeve with a passage merging on that side of the pistonlike body displaceable in the sleeve which is remote from the pistonlike body secured to the sleeve, the construction being such that this passage is in communication with the passage provided in the cylinder for supplying pressurized fluid if the relevant sleeve is retracted into the cylinder.

6. A device as claimed in any one of the preceding Claims, characterized in that the pistonlike body arranged in the cylinder is slidably provided in a cylinder jacket, which is slidably arranged in the cylinder and is displaceable to a limited extent with respect to the cylinder by means of the pressurized fluid to be fed into the cylinder, while a pressure member suitable for engagement with an end of an elongate holder is secured to a part of the cylinder jacket projecting from the cylinder on the same side of the cylinder as the pushing member.

7. A device as claimed in Claim 6, characterized in that the passages provided in the cylinder for the supply of pressurized fluid merge into chambers bounded by the inner wall of the cylinder and by the ends of the cylinder jacket, which have a smaller cross-section than the adjoining parts of the cylinder jacket guided in a sealing manner in the cylinder.

8. A device as claimed in Claim 6 or 7, characterized in that the cylinder jacket is provided with passages for feeding pressurized fluid into the interior of the cylinder jacket on either side of the pistonlike body arranged in the cylinder jacket.

EP 0 350 100 A1

FIG.1

FIG.2

FIG.7

1-II- PHN 12600

FIG.3

FIG.4

FIG.5

FIG.6

EP 0 350 100 A1

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| A | US-A-4488662 (FANNING) <br> * column 5, lines 8 - 16; figures 3, 6 * <br> --- | 1 | H05K13/02 <br> F15B15/16 |
| A <br><br> D | GB-A-2091138 (CITIZEN WATCH COMPANY) <br> * page 3, lines 63 - 78; figure 5 * <br> & US-A-4573261 <br> ----- | 1 | |

TECHNICAL FIELDS SEARCHED (Int. Cl.5 )

H05K
F15B

The present search report has been drawn up for all claims

| Place of search | Date of completion of the search | Examiner |
|---|---|---|
| THE HAGUE | 15 SEPTEMBER 1989 | RIEUTORT A.S. |